Europäisches Patentamt

(19) European Patent Office

Office européen des brevets

(11) Veröffentlichungsnummer: **0 249 691**
**B1**

(12) **EUROPÄISCHE PATENTSCHRIFT**

(45) Veröffentlichungstag der Patentschrift:
18.07.90

(51) Int. Cl.⁵: **G01F 1/66**, G01R 25/08

(21) Anmeldenummer: 87104492.1

(22) Anmeldetag: 26.03.87

(54) **Durchflussvolumenzähler für flüssige Medien.**

(30) Priorität: 17.06.86 CH 2440/86

(43) Veröffentlichungstag der Anmeldung:
23.12.87 Patentblatt 87/52

(45) Bekanntmachung des Hinweises auf die Patenterteilung:
18.07.90 Patentblatt 90/29

(84) Benannte Vertragsstaaten:
AT CH DE FR LI NL SE

(56) Entgegenhaltungen:
CH-A- 604 133
GB-A- 2 014 386

(73) Patentinhaber: LANDIS & GYR GMBH,
Friesstrasse 20-24, D-6000 Frankfurt am Main 60(DE)

(72) Erfinder: Merkel, Jürgen, Siemensallee 8,
D-6457 Maintal 1(DE)
Erfinder: Andersen, Niels Thorup,
Brandenburgerstrasse 25, D-6369 Büdesheim(DE)

(74) Vertreter: Müller, Hans-Jürgen, Dipl.-Ing. et al, Müller,
Schupfner & Gauger
Maximilianstrasse 6 Postfach 10 11 61,
D-8000 München 1(DE)

## Beschreibung

Die Erfindung bezieht sich auf einen Durchflussvolumenzähler für flüssige Medien der im Obergriff des Patentanspruches 1 genannten Art, wie sie z.B. in Wärmezählern verwendet werden.

Durchflussvolumenzähler dieser Art messen die Strömungsgeschwindigkeit und damit den Fluss eines Mediums durch ein Messrohr, basierend auf der Laufzeitdifferenz zweier Ultraschallwellenpakete von z.B. mehr als 100 Perioden, die gleichzeitig das Messrohr in entgegengesetzter Richtung einmal pro Messzyklus durcheilen. In einem ausgewählten Abschnitt der Ultraschallwellenpakete wird in jeder Periode die Phasendifferenz zwischen den auf dem Weg durch das Messrohr durch die Strömung verzögerten bzw. beschleunigten Ultraschallsignalen mit einem Impulssignal ausgemessen und in Mengeneinheiten umgerechnet.

Eine solche dem Stand der Technik entsprechende Einrichtung ist aus der CH-PS 604 133 bekannt.

Charakteristisch für diese Durchflussvolumenzähler ist der Messfehler, welcher nur von der Temperatur und der Ultraschallfrequenz abhängt. Durch Abgleichen der Ultraschallfrequenz kann der Messfehler reduziert werden, sofern die Ultraschallsignale und das Impulssignal keine gemeinsamen Oberwellen haben, d.h. die Phasenlage der beiden Signale während der Messzyklen muss zufällig sein und die Erzeugung beider Signale darf über viele tausend Messzyklen nicht unterbrochen werden.

Dieser Messfehler bestimmt die minimale mit vorgegebener Genauigkeit messbare Durchflussmenge und begrenzt damit die Dynamik des Durchflussvolumenzählers, d.h. das Verhältnis grösster zur kleinster Durchflussmenge bei vorgegebener Messgenauigkeit.

Der Erfindung liegt die Aufgabe zugrunde, die Dynamik des Durchflussvolumenzählers bei vorgegebener Messgenauigkeit durch Beseitigung der Ursachen des obgenannten Messfehlers zu verbessern.

Die Erfindung ist im Anspruch 1 gekennzeichnet. Sie basiert auf einer genaueren Analyse der Phasendifferenzmessmethode.

Nachfolgend werden einige Ausführungsbeispiele der Erfindung anhand der Zeichnungen näher beschrieben. Es zeigen:

Fig. 1: eine Messanordnung eines Durchflussvolumenzählers oder als Teil eines Wärmemengenzählers,

Fig. 2: Zeit-Diagramme mit Steuersignalen eines Steuerwerks und elektrischen Signalen über einem der beiden Messwandler,

Fig. 3: ein Schema eines Oszillators für eine Sendefrequenz,

Fig. 4: den Oszillator nach Fig. 3 mit einer Kapazitätsdiode und

Fig. 5: eine digitalgesteuerte Kapazität des Oszillators nach Fig. 3.

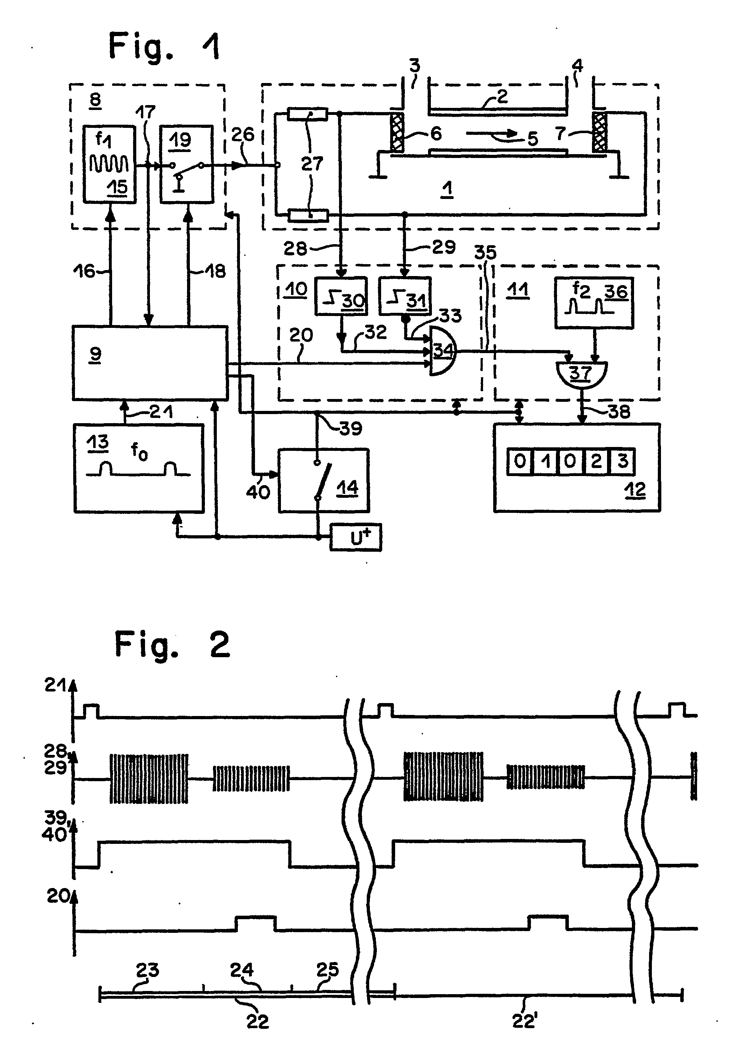

Der in der Fig. 1 dargestellte Durchflussvolumenzähler besteht im wesentlichen aus einem Messwertgeber 1 mit einer Messstrecke 2, in der ein flüssiges Medium von einem Anschlussstutzen 3 zu einem Anschlussstutzen 4 in einer möglichen, mit einem Pfeil 5 angegebenen Strömungsrichtung fliesst, und aus Messwandlern 6 und 7 für Ultraschall, einem Sendeglied 8, einem Steuerglied 9, einem Laufzeitdifferenz-Messglied 10, einer Auswerteeinheit 11, einer Zählvorrichtung 12, einem Impulsgeber 13 mit der Impulsfrequenz $f_0$ und einem Schalter 14 für eine Versorgungsspannung 39. Die Messwandler 6, 7 stehen einander gegenüber und senden periodisch gleichzeitig Ultraschallwellenpakete aus, d.h. je ein Wellenpaket eilt in Richtung des Pfeils 5 und ein Wellenpaket entgegengesetzt dazu. Die am andern Ende der Messstrecke 2 befindlichen Messwandler 7 bzw. 6 empfangen daher ein durch die Strömung beschleunigtes bzw. verzögerter Ultraschallwellenpaket.

Das Sendeglied 8 enthält einen Oszillator 15, dessen Sendefrequenz $f_1$ mittels eines Steuersignals 16 durch das Steuerglied 9 innerhalb eines Wertebereiches um eine Grundfrequenz verändert wird. Ein Ausgangssignal 17 des Oszillators 15 wird im vorzugsweise aus mindestens einer Zählkette bestehenden Steuerglied 9 benutzt, um das Steuersignal 16, ein Kommandosignal 18 für einen Umschalter 19 und ein Freigabesignal 20 für das Messglied 10 zu erzeugen.

Ein vorzugsweise schmaler Impuls 21 aus dem Impulsgeber 13 veranlasst das Steuerglied 9, einen neuen Messzyklus 22, bestehend aus einer Sendephase 23, einer Empfangsphase 24 und einer Ruhephase 25, zu beginnen (Fig. 2). In Fig. 1 gelangt das Ausgangssignal 17 mit der Sendefrequenz $f_1$ über den vom Kommandosignal 18 gesteuerten Umschalter 19 während vorbestimmter Dauer, z.B. während 128 Perioden, als ein Sendesignal 26 über Ankopplungsglieder 27 aus die Messwandler 6 und 7. Die Messwandler 6 und 7 erzeugen im Medium pro Messzyklus 22 je ein Ultraschallwellenpaket der vorbestimmten Dauer.

Die beiden Ultraschallwellenpakete durchlaufen die Messstrecke 2 mit den Geschwindigkeiten $c_0 + c_m$ und $c_0 - c_m$, wobei $c_0$ für die Schallgeschwindigkeit im Medium und $c_m$ für die Strömungsgeschwindigkeit des Mediums steht. Jeder Messwandler 6, 7 wandelt in der Empfangphase 24 (Fig. 2) die vom andern Messwandler 7, 6 (Fig. 1) ausgesandeten Ultraschallwellen in entsprechende elektrische Signale 28 und 29 um. Gleichzeitig wird der gemeinsame Einspeisungspunkt der Ankopplungsglieder 27 vom Umschalter 19 geerdet. Im Laufzeitdifferenz-Messglied 10 werden die Signale 28 und 29 von Schwellwertschaltern 30 und 31 beobachtet. Für die positiven Halbwellen des Signales 28 gibt der Schwellenwertschalter 30 ein Ausgangssignal 32 mit logisch "1" ab; für die negativen Halbwellen ist das Signal 32 auf logisch "0". Der Schwellwertschalter 31 erzeugt ein invertiertes Ausgangssignal 33, das für positive Halbwellen des Signals 29 logisch "0", für dessen negative Halbwellen logisch "1" ist. Das Steuerwerk 9 schaltet das Signal 20 zeitlich im ersten Viertel der Periodenzahl des empfangenen Signals 28 von logisch "0" auf "1" und im letzten Viertel der Periodenzahl des Signals 28 von logisch "1" auf "0". Die Signale 20, 32 und 33 erzeugen im UND-Tor 34 während jeder Empfangsphase 24 eine Folge von Impulsen 35. Die Dauer δ dieser Impulse 35 entspricht der Laufzeitdifferenz Δt der beiden Ultraschallwellen. Mit b als Länge der Messstrecke 2 in Fig. 1 gilt nach CH-PS 604 133:

$$\delta = \Delta t = \frac{b}{c_o - c_m} - \frac{b}{c_o + c_m} \approx 2 \cdot b \cdot c_m / c_o^2$$

In der Auswerteeinheit 11 erzeugt ein vorteilhaft quarzgesteuerter Abtastgenerator 36 vorzugsweise ein Abtastsignal mit schmalen Abtastimpulsen und mit einer konstanten Pulsfrequenz $f_2$.

Ein UND-Tor 37 lässt diese Abtastimpulse während der Dauer δ eines jeden Impulses 35 als Signal 38 zur Zählvorrichtung 12 passieren, wo die Signale 38 aufsummiert werden.

Der Impulsgeber 13 löst über den Impuls 21 den oben beschriebenen Messzyklus 22 aus. Die Impulsfrequenz $f_0$ der Impulse 21 wird der Temperatur des Mediums in der Messstrecke 1 entsprechend zur Kompensation der temperaturabhängigen Schallgeschwindigkeit $C_0$ geeignet verändert im Falle eines reinen Durchflussvolumenzählers. Bei einem Wärmemengenzähler hingegen hängt die Impulsfrequenz $f_0$ der Impulse 21 noch zusätzlich von der Differenz zwischen der Vorlauftemperatur eines Wärmeverbrauchers und dessen Rücklauftemperatur ab.

Eine Speisespannung U+ versorgt den Impulsgeber 13 und das Steuerglied 9 direkt mit elektrischer Energie. Die übrigen Schaltungsbausteine 8, 10, 11 und 12 werden über den Schalter 14 mit der Versorgungsspannung 39 versorgt. Ein im Steuerglied 9 erzeugtes Steuersignal 40 schliesst den Schalter 14 zu Beginn der Sendephase 23 und öffnet den Schalter 14 am Ende der Empfangsphase 24. In Fig. 2 ist die zeitliche Abfolge der Signale 20, 21, 28, 29, 39, 40 während des Messzyklus 22 eingezeichnet.

Die Fig. 3 zeigt eine mögliche Ausführungsform des über die Versorgungsspannung 39 gespeisten Oszillators 15. Er enthält neben einer Strommquelle 41 wengistens zwei MOS-Schalter 42 und einen frequenzbestimmenden Schwingkreis, der aus einem Kondensator 43 und einem Induktor 44 besteht. Mit dem Signal 16 wird die Kapazität des Kondensators 43, die Schwingkreiskapazität, oder die Induktivität des Induktors 44 verändert, um die Sendefrequenz $f_1$ innerhalb des vorbestimmten Wertebereichs zu verschieben. Vorzugsweise wird dazu die Schwingkreiskapazität verwendet und der Induktor 44 nur beim Abgleich der Grundfrequenz verändert.

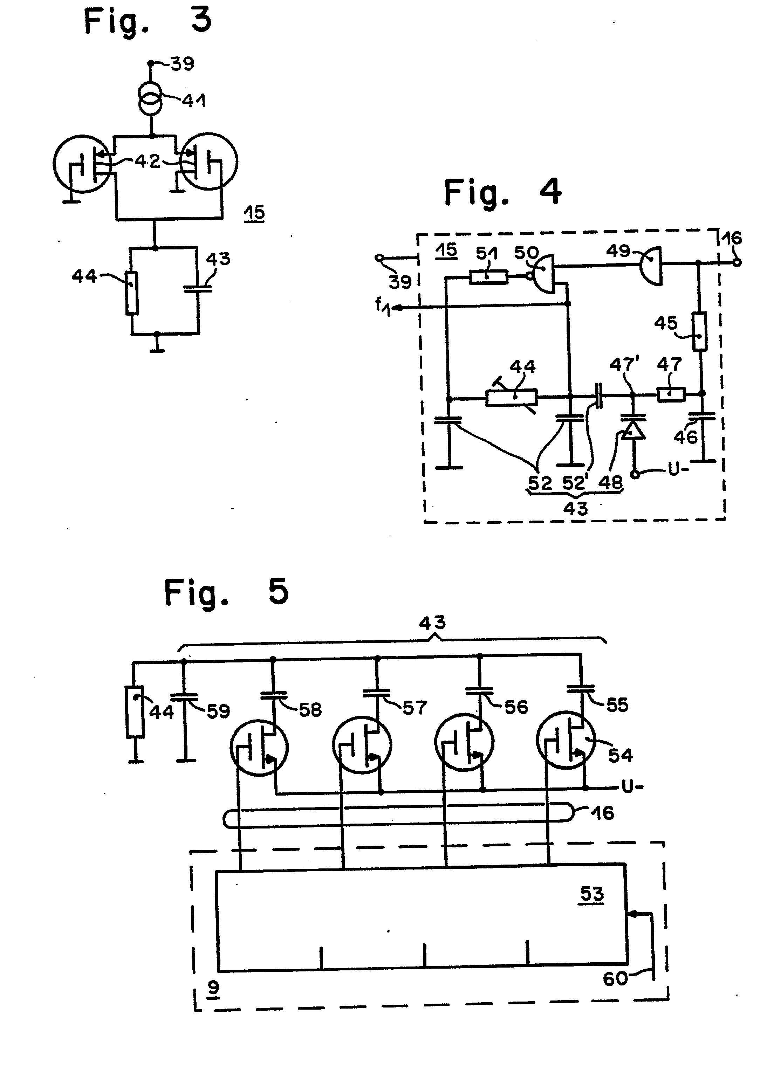

Eine mögliche Ausführungsform für eine kontinuierliche Änderung der Sendefrequenz $f_1$ zeigt die Fig. 4. Der Wechsel des Steuersignals 16 von logisch "1" auf "0" bewirkt über einen Widerstand 45 mit dem Wert R ein Absinken der Spannung mit einer Zeitkonstante t über einem Kondensator 46 mit der Kapazität C. Die Zeitkonstante t=RC wird vorzugsweise gleich der Zeit gewählt, während der das Steuersignal 16 auf logisch "0" bleibt. Die Spannung am Kondensator 46 wird über eine Widerstand 47 durch einen Verknüpfungspunkt 47' an eine Kapazitätsdiode 48 geleitet und verändert deren Kapazität entsprechend der momentanen Spannungsdifferenz über der Diode 48 zwischen dem Verknüpfungspunkt 47' und einer negativen Spannungsquelle U-. Das Steuersignal 16 gibt über ein invertierendes CMOS-Tor 49 den aus einem invertierenden CMOS-Tor 50, einem Widerstand 51, dem Induktor 44 und dem Kondensator 43 bestehenden Oszillator 15 in an sich üblicher Schaltung zum Schwingen frei. Der Schwingkreiskondensator 43 setzt sich aus den Kondensatoren 52 und der Kapazitätsdiode 48 zusammen. Die Kapazitätsdiode 48 ist vorteilhaft mit einem Koppelkondensator 52' zwischen dem Verknüpfungspunkt 47' und dem schwingkreisseitigen Eingang des CMOS-Tores 50 verbunden. Das Steuersignal 16 wird vorteilhaft erst aktiv, nachdem die Versorgungsspannung 39 zugeschaltet ist. Während der Sendephase 23 durchläuft die Sendefrequenz $f_1$ mit Vorteil den ganzen vorbestimmten Wertebereich.

In einer weiteren möglichen Ausführungsform des Oszillators 15 wird die Sendefrequenz $f_1$ vorteilhaft stufenweise innerhalb des vorbestimmten Wertebereichs verändert, durch z.B. stufenweise Erhöhung der kapazitätsbestimmenden Spannung über der Diode 48. Mit Vorteil bleibt die Sendefrequenz $f_1$ in dieser Ausführung während eines Messzyklus 22 konstant und springt auf einen neuen Frequenzwert zu Beginn des nächsten Messzyklus 22' (Fig. 2). Die kapazitätsbestimmende Spannung über der Diode 48 liefert vorzugsweise ein mit dem Steuersignal 16 gesteuerter Digital-Analog-Wandler.

Eine vorteilhafte für das stufenweise Verändern der Sendefrequenz $f_1$ einfachere und daher kostengünstigere Ausführung des in der Fig. 3 frequenzbestimmenden Schwingkreiskondensators 43 als digital gesteuerter Kondensator ist beispielshaft in der Fig. 5 dargestellt. Diese Ausführungsform besteht aus einem z.B. vierstufigen binären Teiler 53 der Zählkette im Steuerglied 9, vier MOS-Schaltern 54, Kondensatoren 55, 56, 57 und 58, und einem Kondensator 59 für den Minimalwert der Schwingkreiskapazität. Der digitalgesteuerte Kondensator ist im Schwingkreis parallel zum Induktor 44 geschaltet.

Eine aus der Zählkette im Steuerglied 9 gewonnene Impulsfolge wird im vierstufigen Teiler 53 binär aufgezählt, so dass das binare Steuersignal 16 des vierstufigen Teilers 53 über die MOS-Schalter 54, beginnend mit dem Kondensator 55 mit der kleinsten Kapazität C1, den Kondensator 56 mit $2 \cdot C1$, den Kondensator 57 mit $4 \cdot C1$ und den Kondensator 58 mit $8 \cdot C1$ gemäss der binären Zahlendarstellung über die negative Spannungsquelle U- zum Verändern des Schwingkreiskondensators 43 zu- oder wegschalten. In einem Ausführungsbeispiel mit C1 = 0,4 pF und einer Kapazität von 60 pF des Kondensators 59 und einer Induktivität von 0,4 mH des Induktors 44 durchläuft die Sendefrequenz $f_1$ den

5  EP 0 249 691 B1  6

vorbestimmten Wertebereich von ± 30 kHz bei einer Grundfrequenz 1 MHz in 16 Stufen.

Die Grundfrequenz wird mit dem Induktor 44 auf bzw. möglichst nahe der Resonanzfrequenzen der Messwandler 6, 7 in Fig. 1 abgeglichen, damit die Umwandlung der elektrischen Signale 28, 29 in akustische Wellen und umgekehrt mit höchstem Wirkungsgrad erfolgt.

Beim Empfang der Ultraschallwellen wird ein Teil der Schallenergie wieder in das Medium zurückgestreut und kann von der Umgebung in die Messwandler 6, 7 reflektiert werden. Interferenzen zwischen den direkten und den gestreuten und reflektierten Ultraschallwellen verzerren die empfangenen Signale 28 und 29. Die Dauer δ der Impulse 35 entspricht daher nicht mehr genau der Laufzeitdifferenz Δt, d.h. es entsteht ein Messfehler. Der Abgleich der Grundfrequenz, wie oben beschrieben, reduziert diesen temperaturabhängigen Messfehler. Wie die Temperatur des Mediums verändert auch eine kleine Änderung der Sendefrequenz $f_1$ die Länge der Ultraschallwellen und damit Interferenzbedingungen. Wird die Sendefrequenz $f_1$ in einem vorbestimmten Wertebereich während eines oder mehrerer Messzyklen 22 verändert, mitteln sich diese durch Interferenzen verursachten Messfehler aus.

Die Zufälligkeit der Phasenlage zwischen den Sendesignalen 26 mit der Sendefrequenz $f_1$ de Oszillators 15 und den Abtastsignalen mit der Pulsfrequenz $f_2$ des Abtastgenerators 36 stellt die vorteilhafte Verwendung der Kombination eines Oszillators mit Quarzsteuerung im Abtastgenerator 36, einem wie oben beschriebenen Oszillator 15 und das Aus- und Einschalten der Versorgungsspannung 39 in jedem Messzyklus 22 sicher. Während der Oszillator 15 beim Einschalten der Versorgungsspannung 39 in einer definierten Phasenlage sofort anschwingt, hängt die Verzögerung bis zum Anschwingen und damit die Phasenlage des Abtastgenerators 36 vom zufälligen Anteil der Pulsfrequenz $f_2$ im bis zum Anschwingen erzeugten Rauschen ab.

In einer andern Ausführung kann die Zufälligkeit der Phasenlage zwischen der Sendesignale 26 und der Abtastsignalen des Abtastgenerators 36 z.B. mittels eines Zufallsgenerators für jeden Messzyklus 22 eine vorbestimmte Phasenlage beider Signale ausgewählt werden.

Das Entfallen der Dauerbetriebsbedingung für den mit der Versorgungsspannung 39 gespeisten Teil der Elektronik ist für eine Batteriespeisung des Durchflussvolumenzählers vorteilhaft.

Mit der beschriebenen Einrichtung wird eine genügende Massgenauigkeit auch bei einer starken Reduktion der Impulsfrequenz $f_0$ der die Messzyklen 22 auslösenden Impulse 21 erreicht, z.B. ein Messzyklus 22 pro Sekunde.

Für eine Kalibrierung des Durchflussvolumenzählers ist es vorteilhaft, die Impuls-Frequenz $f_0$ der Impulse 21 mittels eines in der Fig. 1 nicht eingezeichneten Hilfsschalters am Impulsgeber 13 zu erhöhen, z.B. auf 32 oder 64 Messzyklen 22 pro Sekunde.

## Patentansprüche

1. Durchflussvolumenzähler für flüssige Medien mit einer Ultraschallmessstrecke (2), einem ersten Messwandler (6) und einem zweiten Messwandler (7) für Ultraschall, die mit einem Messglied (10) und mit einem in einem Sendeglied (8) eingebauten, der Erzeugung eines Sendesignals (26) mit einer Sende-Frequenz $(f_1)$ zur periodischen wiederholten Aussteuerung der beiden Messwandler (6, 7) dienenden Oszillator (15) verbunden sind, in dem das Messglied (10) die auf der Messstrecke (2) durch die Strömung des Mediums verursachte Differenz der Ultraschallaufzeit zwischen dem ersten Messwandler (6) als Sender und dem zweiten Messwandler (7) als Empfänger einerseits und der Laufzeit zwischen dem zweiten Messwandler (7) als Sender und dem ersten Messwandler (6) als Empfänger andererseits misst, einem Impulsgeber (13) zum wiederholten Auslösen eines Messzyklus (22), einem Steuerglied (9), einer Auswerteeinrichtung (11) zur Umwandlung der Laufzeitdifferenzen in Einheiten proportional zum Volumen des pro Zeiteinheit durch die Messstrecke (2) fliessenden Mediums und einer Zählvorrichtung (12) zum Aufsummieren dieser Einheiten, dadurch gekennzeichnet, dass der Oszillator (15) eine Vorrichtung (43, 44; 43, 52', 48; 9, 44, 54 bis 59) zum Verändern der Sendefrequenz $(f_1)$ in einem vorbestimmten Wertebereich enthält, dass in der Auswerteinrichtung (11) ein Abtastgenerator (36) zur Erzeugung von Abtastsignalen mit einer Pulsfrequenz $(f_2)$ vorgesehen ist und dass für alle Messzyklen (22) die vom Abtastgenerator (36) bestimmte Phasenlage zwischen den Sendesignalen (26) und den Abtastsignalen zufällig verteilte Werte aufweisen.

2. Durchflussvolumenzähler nach Anspruch 1, dadurch gekennzeichnet, dass ein Schalter (14) zum Abschalten einer Versorgungsspannung (39) des Oszillators (15) und des Abtastgenerators (36) in der Ruhephase (25) eines jeden Messzyklus (22) und zum Einschalten der Versorgungsspannung (39) des Oszillators (15) und des Abtastgenerators (36) zu Beginn der Sendephase (23) eines jeden Messzyklus (22) zur Sicherstellung der Zufälligkeit der Phasenlage zwischen den Sendesignalen (26) und den Abtastsignalen vorgesehen ist.

3. Durchflussvolumenzähler nach Anspruch 1 oder 2, dadurch gekennzeichnet, dass die Sendefrequenz $(f_1)$ während eines Messzyklus (22) den ganzen vorbestimmten Wertebereich durchläuft.

4. Durchflusszähler nach Anspruch 1 oder 2, dadurch gekennzeichnet, dass die Sendefrequenz $(f_1)$ während jedem Messzyklus (22) konstant ist und die Sendefrequenz $(f_1)$ den vorbestimmten Wertebereich in aufeinanderfolgenden Messzyklen (22) immer wieder durchläuft.

5. Durchflussvolumenzähler nach einem der vorangehenden Ansprüche, dadurch gekennzeichnet, dass durch die Resonanzfrequenzen der beiden Messwandler (6; 7) die Lage des vorbestimmten Wertebereiches der Sendefrequenzen $(f_1)$ bestimmt ist.

6. Durchflussvolumenzähler nach einem der vorangehenden Ansprüche, dadurch gekennzeichnet, dass der Oszillator (l5) einen aus einem Induktor (44) und einem Kondensator (43) gebildeten Schwingkreis aufweist.

7. Durchflussvolumenzähler nach einem der vorangehenden Ansprüche, dadurch gekennzeichnet, dass der Abtastgenerator (36) quarzgesteuert ist.

8. Durchflussvolumenzähler nach einem der vorangehenden Ansprüche, dadurch gekennzeichnet, dass die Sendefrequenz ($f_1$) des Oszillators (l5) mittels einer Kapazitätsdiode (48), die einen Teil des Kondensators (43) bildet, veränderbar ist.

9. Durchflussvolumenzähler nach einem der Ansprüche I bis 6, dadurch gekennzeichnet, dass der die Sendefrequenz ($f_1$) bestimmende Kondensator (43) des Oszillators (l5) stufenweise veränderbar ist.

10. Durchflussvolumenzähler nach einem der vorangehenden Ansprüche, dadurch gekennzeichnet, dass ein Hilfsschalter am Impulsgeber (l3) die Frequenz ($f_0$) der Impulse (2l) zu Kalibrierzwecken erhöht.

## Claims

1. A flow volume meter for fluid media comprising an ultrasound measuring section (2), a first measuring transducer (6) and a second measuring transducer (7) for ultrasound, which are connected to a measuring member (10) and an oscillator (15) which is installed in a transmission member (8) and serves to produce a transmission signal (26) with a transmission frequency ($f_1$) for the periodic repeated actuation of the two measuring transducers (6, 7), in which the measuring member (10) measures the difference, caused in the measuring section (2) by the flow of medium, in the ultrasound transit time between the first measuring transducer (6) as a transmitter and the second measuring tranducer (7) as a receiver on the one hand and the transit time between the second measuring transducer (7) as a transmitter and the first measuring transducer (6) as a receiver on the other hand, a pulse generator (13) for repeatedly triggering off a measuring cycle (22), a control member (9), an evaluation means (11) for converting the transit time differences into units in proportion to the volume of the medium flowing per unit of time through the measuring section (2), and a counting means (12) for summing those units, characterised in that the oscillator (15) includes a means (43, 44; 43, 52, 52', 48; 9, 44, 54 to 59) for varying the transmission frequency ($f_1$) in a predetermined range of values, that provided in the evaluation means (11) is a sampling generator (36) for producing sampling signals at a pulse frequency ($f_2$) and that for all measuring cycles (22) the phase position determined by the sampling generator (36) between the transmission signals (26) and the sampling signals have randomly distributed values.

2. A flow volume meter according to claim 1 characterised in that there is provided a switch (14) for switching off a supply voltage (39) for the oscillator (15) and the sampling generator (36) in the rest phase (25) of each measuring cycle (22) and for switching on the supply voltage (39) of the oscillator (15) and the sampling generator (36) at the beginning of the transmission phase (23) of each measuring cycle (22) to ensure the random nature of the phase position as between the transmission signals (26) and the sampling signals.

3. A flow volume meter according to claim 1 or claim 2 characterised in that the transmission frequency ($f_1$) passes through the entire predetermined range of values during a measuring cycle (22).

4. A flow volume meter according to claim 1 or claim 2 characterised in that the transmission frequency ($f_1$) is constant during each measuring cycle (22) and the transmission frequency ($f_1$) passes again and again through the predetermined range of values in successive measuring cycles (22).

5. A flow volume meter according to one of the preceding claims characterised in that the position of the predetermined range of values of the transmission frequencies ($f_1$) is determined by the resonance frequencies of the two measuring transducers (6; 7).

6. A flow volume meter according to one of the preceding claims characterised in that the oscillator (15) has an oscillator circuit formed from an inductor (44) and a capacitor (43).

7. A flow volume meter according to one of the preceding claims characterised in that the sampling generator (36) is quartz-controlled.

8. A flow volume meter according to one of the preceding claims characterised in that the transmission frequency ($f_1$) of the oscillator (15) is variable by means of a capacitance diode (48) which forms a part of the capacitor (43).

9. A flow volume meter according to one of claims 1 to 6 characterised in that the capacitor (43) of the oscillator (15), which capacitor determines the transmission frequency ($f_1$), is variable stepwise.

10. A flow volume meter according to one of the preceding claims characterised in that an auxiliary switch at the pulse generator (13) increases the frequency ($f_0$) of the pulses (21) for calibration purposes.

## Revendications

1. Compteur de débit volumique pour milieux fluides comprenant une distance de mesure par ultrasons (2), un premier transducteur de mesure (6) et un deuxième transducteur de mesure (7) pour ultrasons, qui sont reliés à un organe de mesure (10) et à un oscillateur (15) monté dans un organe émetteur (8), servant à créer le signal d'émission (26) d'une fréquence d'émission $f_1$ pour la modulation répétée de façon périodique des deux transducteurs de mesure (6, 7), dans lequel l'organe de mesure (10) mesure la différence provoquée, sur la distance de mesure (2), par l'écoulement du milieu entre d'une part le temps de parcours d'ultrasons entre le premier transducteur de mesure (6) agissant comme émetteur et le deuxième transducteur de mesure (7) agissant comme récepteur et d'autre part le temps de parcours entre le deuxième transducteur de mesure (7) agissant comme émetteur et le premier transducteur de mesure (6) agissant comme récepteur, un générateur d'impulsions (13) pour déclencher de façon répétée un cycle de mesure (12), un organe de commande (9), un dispositif d'évaluation (11) pour transformer les différences de temps de parcours en unités proportionnellement au volume du milieu s'écoulant à travers la distance de mesure (2) par unité de temps, et un dispositif de comptage (12) pour sommer ces unités, caractérisé en ce que l'oscillateur (15) contient un dispositif (43, 44; 43, 52, 52', 48; 9, 44, 54 à 59) pour modifier la fréquence d'émission $f_1$ dans une plage de valeur définie au préalable, en ce qu'un générateur de détection (36) destiné à créer des signaux de détection selon une fréquence d'impulsions $f_2$ est disposé dans le dispositif d'évaluation (11) et en ce que, pour tous les cycles de mesure (22), la position de phase définie par le générateur de détection (36), entre les signaux d'émission (26) et les signaux de détection, présente des valeurs réparties de façon aléatoire.

2. Compteur de débit volumique selon la revendication 1, caractérisé en ce qu'il comprend un commutateur (14) pour déconnecter une tension d'alimentation (39) de l'oscillateur (15) et du générateur de détection (36) dans la phase de repos de chaque cycle de mesure (22) et pour connecter la tension d'alimentation (39) de l'oscillateur (15) et du générateur de détection (36) au début de la phase d'émission (23) de chaque cycle de mesure (22) pour garantir le caractère aléatoire de la position de phase entre les signaux d'émission (26) et les signaux de détection.

3. Compteur de débit volumique selon la revendication 1 ou 2, caractérisé en ce que la fréquence d'émission $f_1$ parcourt toute la plage de valeurs déterminée au préalable au cours d'un cycle de mesure (22).

4. Compteur de débit volumique selon la revendication 1 ou 2, caractérisé par le fait que la fréquence d'émission ($f_1$) est constante en cours de chaque cycle de mesure (22) et que la fréquence d'émission ($f_1$) parcourt la plage de valeurs déterminée au préalable au cours des cycles de mesure successifs (22).

5. Compteur de débit volumique selon l'une des revendications précédentes, caractérisé par le fait que la position dans la plage de valeurs déterminée de la fréquence d'émission est définie à l'aide de la fréquence de résonance des deux transducteurs de mesure (6; 7).

6. Compteur de débit volumique selon l'une des revendications précédentes, caractérisé par le fait que l'oscillateur (15) possède un circuit oscillant formé d'une inductance (44) et d'un condensateur (43).

7. Compteur de débit volumique selon l'une des revendications précédentes, caractérisé par le fait que le générateur de détection (36) est commandé par quartz.

8. Compteur de débit volumique selon l'une des revendications précédentes, caractérisé par le fait que la fréquence d'émission ($f_1$) de l'oscillateur (15) peut être modifiée par une diode capacitive (48) qui forme une partie du condensateur (43).

9. Compteur de débit volumique selon l'une des revendications 1 à 6, caractérisé par le fait que le condensateur (43) de l'oscillateur (15) déterminant la fréquence d'émission ($f_1$) peut être modifié par pas.

10. Compteur de débit volumique selon l'une des revendications précédentes, caractérisé par le fait qu'un commutateur auxiliaire prévu sur le générateur d'impulsions (13) augmente la fréquence ($f_0$) des impulsions (21) à des fins de calibration.

# Fig. 1

# Fig. 2

Fig. 3

Fig. 4

Fig. 5